Europäisches Patentamt

European Patent Office

Office européen des brevets

(11) Publication number: **0 381 268**
**A1**

# EUROPEAN PATENT APPLICATION

(21) Application number: **90200175.9**

(22) Date of filing: **24.01.90**

(51) Int. Cl.5: **H01L 29/60, H01L 29/06, H01L 29/784, H01L 29/72, H01L 29/10**

(30) Priority: **30.01.89 GB 8901999**

(43) Date of publication of application:
**08.08.90 Bulletin 90/32**

(84) Designated Contracting States:
**DE FR GB IT NL**

(71) Applicant: **PHILIPS ELECTRONIC AND ASSOCIATED INDUSTRIES LIMITED**
**Philips House 188 Tottenham Court Road London W1P 9LE(GB)**

(84) **GB**

Applicant: **N.V. Philips' Gloeilampenfabrieken**
**Groenewoudseweg 1**
**NL-5621 BA Eindhoven(NL)**

(84) **DE FR IT NL**

(72) Inventor: **Beech, Clive David, c/o Philips Components**
**Bramhall Moor Lane, Hazel Grove Stockport, Cheshire, SK7 5BP(GB)**

(74) Representative: **Clark, Jane Anne et al**
**PHILIPS ELECTRONICS Patents and Trade Marks Department Philips House 188 Tottenham Court Road London W1P 9LE(GB)**

(54) **A field effect semiconductor device.**

(57) A field effect semiconductor device with a semiconductor body (1) having a first region (2) of one conductivity type adjacent a given surface (3) of the body, a second region (4) of the opposite conductivity type provided within the first region (2) adjacent the given surface (3), and a third region (5) of the one conductivity type provided in the second region (4) adjacent the given surface (3). An insulated gate (6) is provided on the given surface (3) overlying a channel area (7) of the second region (4) for defining a gateable conductive path along the length ($l$) of the channel area (7) between the third and first regions (5 and 2). The given surface (3) is profiled, for example by one or more grooves (8), in the region of the channel area in a direction extending transversely of the length ($l$) of the channel area (7) so as to increase the effective width of the channel area (7).

FIG.1

## A FIELD EFFECT SEMICONDUCTOR DEVICE

This invention relates to a field effect semiconductor device comprising a semiconductor body having a first region of one conductivity type adjacent a given surface of the body, a second region of the opposite conductivity type provided within the first region adjacent the given surface, a third region of the one conductivity type provided in the second region adjacent the given surface and an insulated gate provided on the given surface overlying a channel area of the second region for defining a gateable conductive path along the length of the channel area between the third and first regions.

The field effect semiconductor device may be, for example, a MOSFET where the channel area is defined by a DMOS (double-diffused MOS) process, that is where the insulated gate is used as a mask for the introduction of the impurities to form the second region and the third region, which in this case forms the source region of the device, so that the channel length is defined by the difference in the lateral diffusion beneath the insulated gate of the impurities forming the second and source regions. Various forms of vertical DMOSFETs, that is DMOSFETs where the source and drain contacts are provided on opposed surfaces of the semiconductor body, are described in the introduction of an article entitled "A Qualitative study of the DC Performance of SIPMOS transistors" by J. Tihanyi published in Siemens Forschungs-und Entwicklungs-Berichte Bd 9 (1980) Nr. 4 at pages 181 to 189.

Various advantages may be gained from reducing the dimensions of a field effect semiconductor device. Thus, for example, a reduction in dimensions enables more devices or chips to be produced from a single semiconductor wafer which results in a reduction in costs and, for example in the case of a device such as a vertical DMOSFET which comprises a large number of parallel-connected source cells with a common drain, reducing dimensions enables the density of source cells in a device or chip to be increased which in addition to reducing costs should reduce the on-resistance of the MOSFET. However reducing the dimensions of a field effect semiconductor device results in a reduction in the width of the channel area which may detrimentally increase the on resistance.

The present invention aims at providing a field effect semiconductor device which enables the dimensions to be reduced as described above whilst avoiding or at least reducing problems which may arise from a reduction in the width of the channel area.

According to the present invention, there is provided a field effect semiconductor device comprising a semiconductor body having a first region of one conductivity type adjacent a given surface of the body, a second region of the opposite conductivity type provided within the first region adjacent the given surface, a third region of the one conductivity type provided in the second region adjacent the given surface and an insulated gate provided on the given surface overlying a channel area of the second region for defining a gateable conductive path along the length of the channel area between the third and first regions, characterised in that the given surface is profiled in the region of the channel area in a direction extending transversely of the length of the channel area so as to increase the effective width of the channel area.

Thus, in a field effect semiconductor device embodying the invention, the width of the channel area can be increased beyond that of a comparable conventional channel area without having to increase dimensions along the surface so that, for example, the dimensions of the second and third regions and the insulated gate may be made small to reduce the area of the wafer occupied by the device without the necessity for a similar scale reduction in the width of the channel area. The given surface may be profiled in the region of the channel area by causing the given surface to undulate. This may be achieved relatively simply and easily by defining one or more grooves in the said region of the given surface extending along the length of the channel area. The or each groove may have a smoothly varying profile in cross-section or may be formed by an anisotropic etching process which etches preferentially on planes parallel to the given surface.

The device may be a vertical device so that the first region provides a conductive path from the third region via the gateable conductive path to an anode or drain adjacent a surface of the semiconductor body opposed to the given surface. In particular, the device may be a vertical DMOSFET or insulated gate bipolar transistor where the semiconductor body has a plurality of second regions disposed spaced apart within the first region adjacent the given surface with a respective third region being provided in each second region and a respective insulated gate being provided on the given surface overlying a channel area of the associated second region and the first region provides a conductive path from each third region via the associated gateable conductive path to a common anode or drain adjacent the surface of the semiconductor body opposed to the given surface. In such an arrangement, adjacent second regions may be separated at the given surface by one or more further grooves extending into the given surface so that the insulated gate extends over and follows the further grooves. The further grooves act to inhibit pinch-off of the parasitic JFET (junction FET) defined by adjacent second regions and should also assist in reducing the on-resistance of the device because in operation of the device an accumulation layer forms at the surface of the grooves to provide a relatively high mobility conductive path into the first region.

Embodiments of the invention will now be described, by way of example, with reference to the accompanying drawings, in which:

Figure 1 is a schematic plan view, with overlying metallisation omitted, of part of a vertical field effect semiconductor device embodying the invention;

Figure 1a is a cross-sectional view taken along the line I-I in Figure;

Figure 2 is a cross-sectional view taken along line II-II in Figure 1;

Figure 3 is a cross-sectional view taken along line III-III in Figure 1 and showing the metallisation;

Figure 4 is a schematic plan view, similar to Figure 1, of a modified vertical field effect semiconductor device embodying the invention;

Figure 5 is a cross-sectional view taken along line V-V in Figure 4; and

Figure 6 is a cross-sectional view taken along line VI-VI in Figure 4 and showing the metallisation.

It should be understood that the Figures are merely schematic and are not drawn to scale. In particular certain dimensions such as the thickness of layers or regions may have been exaggerated whilst other dimensions may have been reduced. It should also be understood that the same reference numerals are used throughout the Figures to indicate the same or similar parts.

Referring now to the drawings, a field effect semiconductor device comprises a semiconductor body 1 having a first region 2 of one conductivity type adjacent a given surface 3 of the body 1, a second region 4 of the opposite conductivity type provided within the first region 2 adjacent the given surface 3, a third region 5 of the one conductivity type provided in the second region 4 adjacent the given surface 3 and an insulated gate 6 provided on the given surface 3 overlying a channel area 7 of the second region 4 for defining a gateable conductive path along the length 1 of the channel area 7 between the third 5 and first regions 2.

In accordance with the invention, the given surface 3 is profiled in the region of the channel area 7 in a direction extending transversely of the length 1 of the channel area so as to increase the effective width w of the channel area 7.

The given surface 3 may be profiled by causing the given surface 3 to undulate in the region of the channel area 7 in a direction transverse to the conductive path. For example, as shown in the Figures, one or more grooves 8 may be defined extending along the length 1 of the channel area 7.

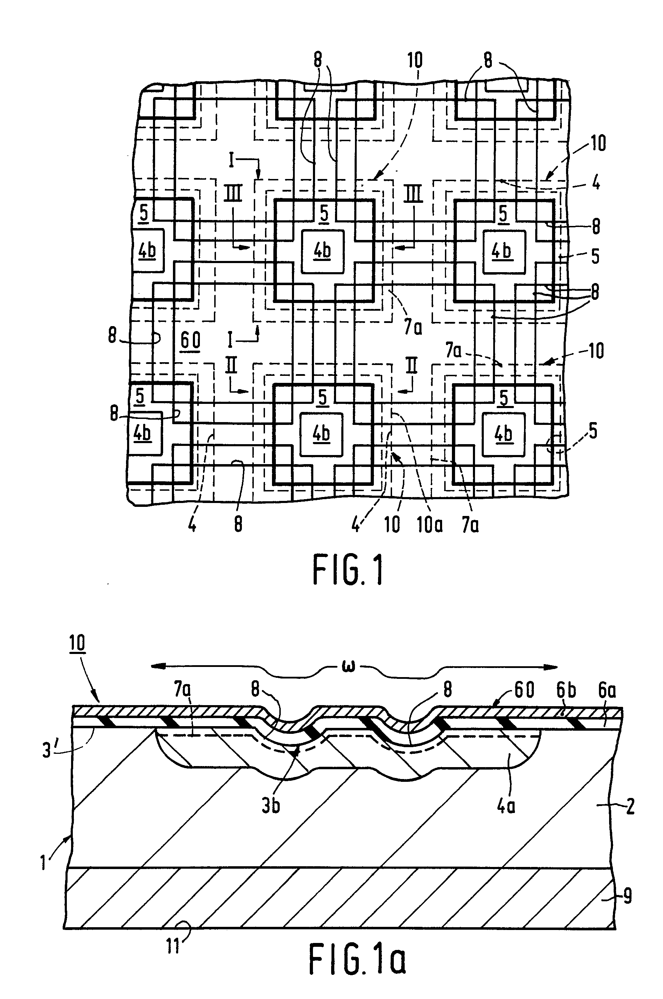

Referring now specifically to Figures 1 to 3, there is shown a vertical DMOSFET embodying the invention.

As is conventional in the art, the vertical DMOSFET comprises many hundreds of parallel-connected source cells 10 (only four of which are shown completely in Figure 1) with a common drain region provided by the semiconductor body 1.

In this example, the semiconductor body 1 comprises a monocrystalline silicon substrate 9 which is highly doped with impurities of the one conductivity type (n+ conductivity type in this example, where the plus sign indicates relatively high doping) onto which a layer of silicon relatively lowly doped with impurities of the one conductivity type (n- conductivity type in this example, where the minus sign indicates relatively low doping) has been epitaxially grown to form the first region 2 which will provide a common drain drift region of the vertical DMOSFET. The semiconductor body 1 is arranged so that the given surface 3 and the opposed surface 11 of the semiconductor body lie along (100) crystal planes.

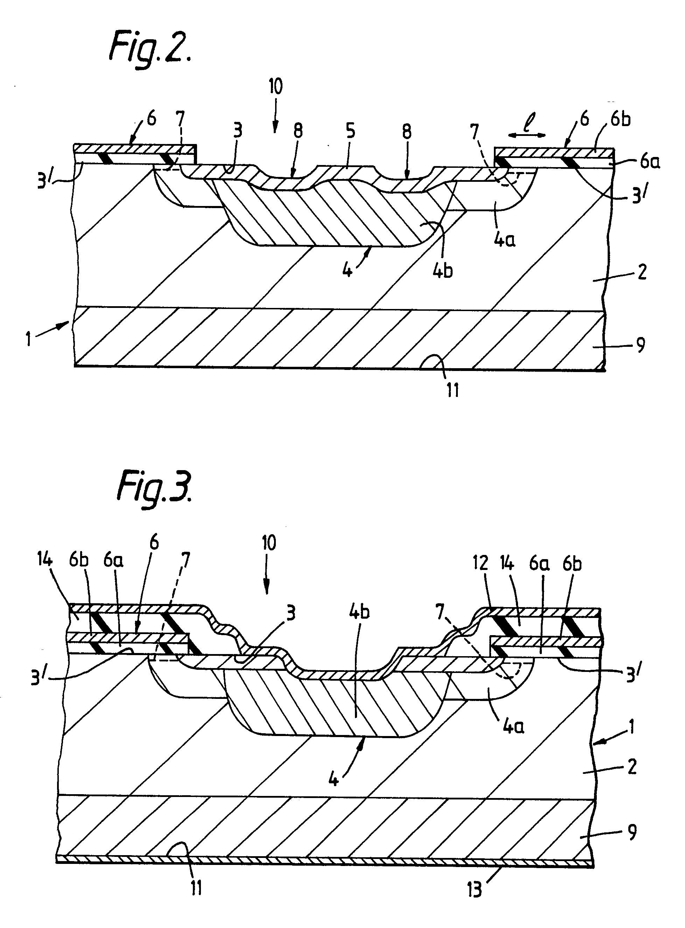

As can be seen most clearly from Figures 2 and 3, each source cell 10 comprises a second or body region 4 of the opposite conductivity type (p conductivity type in this example) within which the third region 5 of the one conductivity type (n+ conductivity type in this example) forming the source region of the source cell 10 is provided so that the channel area 7 surrounds the source region 5 as can be seen most clearly from Figure 1 where the source and second regions 5 and 4 are indicated in dashed lines. In the example shown each second region 4 comprises a relatively lowly doped relatively shallow outer subsidiary region 4a and a relatively highly doped relatively deep central subsidiary region 4b so that, as is conventional in the art, the channel area 7 is defined by the outer subsidiary region 4a and the central subsidiary region 4b being highly doped assists in preventing conduction of the inherent parasitic bipolar transistor. The insulated gate 6 overlying the channel area 7 forms a border around the source cell 10.

As shown in Figure 1, the insulated gates 6 of adjacent source cells 10 meet over the area 3' of the given surface 3 where the first region 2 meets the given surface 3 between adjacent source cells 10 so that there is a single continuous insulated gate layer 60. In order to illustrate more clearly the bounds of the gate layer 60, the edges of the gate layer are depicted by thicker lines. It is, of course, possible that the portion of the insulated gate layer 60 overlying the said areas 3' where the first region 2 meets the given surface 3 could be omitted in which case there would be a separate insulated gate 6 surrounding each source cell 10.

The source cells 10 when viewed in plan may have any desired conventional geometry and layout. In the example shown in Figure 1, the source cells 10 are square (in practice the corners of the squares will be rounded off so as to avoid excessively high fields at the corners), that is the second and source regions 4 and 5 of a source cell are formed so as to have concentric square outlines so that the channel area 7 of a source cell 10 has four connected channel regions 7a each associated with a respective side 10a of the source cell. As shown in Figure 1, the square outline source cells 10 are arranged in a square or rectangular pattern matrix although of course the source cells 10 could be arranged in an offset pattern. As alternatives to a square outline, the source cells 10 may have a circular outline or may have a polygonal, for example, hexagonal outline in which case the source cells 10 may be arranged in a hexagonal array.

The given surface 3 is profiled in the region 3b of the channel area 7 of each source cell 10 in a direction extending transversely of the length 1 of the channel area 7 so that the width w of the channel area 7 is increased in comparison to what the width would have been if the region 3b were still flat, that is in this particular example, if the region 3b still lay in the (100) plane of the surface 3.

In this example the regions 3b of the surface 3 are profiled by defining undulations in the form of the grooves 8 which extend along the length 1 of the channel area 7. Where, as shown in Figure 1, the source cells 10 have a square outline and are arranged in a square array, then the grooves 8 may be rectangular in plan and extend transversely, as shown perpendicularly, of the edges 10a of the square outline source cells 10. As illustrated in Figure 1, each groove 8 is associated with two source cells 10, that is each groove 8 extends along the length of the region 7a of the channel area 7 at a side edge 10a of one source cell and continues across the area 3' of the first region 2 between adjacent source cells 10 and along the length of the channel region 7a of the channel area 7 at the opposed side edge 10a of the adjacent source cell 10 so that the grooves 8 associated with a given source cell 10 define a cross-like pattern. Although only two parallel grooves are shown associated with each region 7a of each channel area 7 in Figure 1, more grooves 8 may be provided and the number of grooves 8 used will depend on the particular design requirements.

Although it is convenient from the point of view of, for example, manufacturing tolerances for the grooves 8 to extend as shown into the source regions 5 and across the areas 3' where the first region 2 meets the given surface 3 between adjacent source cells 10, this need not necessarily be the case and where manufacturing tolerances allow the grooves 8 may be confined almost entirely to the channel areas 7.

The necessary source and drain metallisation 12 and 13 (Figure 3) and gate metallisation (not shown in the Figures) is provided in conventional manner as will be appreciated from the following description of a method of manufacturing the device shown in Figures 1 to 3.

In order to enable the use of a self-aligned or DMOSFET technology, the grooves 8 are defined first, after the usual cleaning and preparation of the given surface 3 of the semiconductor body 1. Any suitable technique may be used to form the grooves. Thus, for example, the grooves 8 may be etched through an appropriate mask using a conventional isotropic wet etching technique, for example HF, which will result, as shown in Figures 2 and 3, in round bottomed grooves 8. Alternatively an anisotropic etching process which selectively etches more quickly along certain crystal planes, that is which etches more quickly along (100) planes than along (111) planes where the given surface 3 lies in a (100) plane may be used to form a V groove where the side walls of the groove are defined by (111) planes or, by terminating the anisotropic etching early, to form a flat-bottomed V groove. Such selective etching may be carried out using any suitable conventional etchant, for example aqueous potassium hydroxide, hydrazine or ethylene diamine. The details of these selective etching processes are well documented and will not be described here.

As an alternative to the above two described etching processes, a reactive ion etching (RIE) process may be used to etch the grooves 8 as rectangular trenches. Thus, for example, a gas mixture of $CCl_4 + SF_6 + HCl$ may be used for the reactive ion etching. Where reactive ion etching is used, a short subsequent isotropic wet etch in, for example, an $HF/HNO_3$ mixture maybe used to ensure that the walls of the grooves 8 slope to some degree to facilitate formation of the subsequent gate oxide layer.

The precise dimensions of the grooves 8 will depend on the dimensions of the source cells 10 and process conditions. Where the vertical DMOSFET is to be, for example, a 50 volt device and source cells 10 are dimensioned such that the second regions 4 have a side length of about 16 micrometres and a depth of about 2 micrometres with a gate length from cell to cell of about 8 micrometres and with the source regions 5 having a depth of about 0.2 micrometres, then each groove 8 may have, for example, a width (that is the dimension in the direction of the width w of the channel) of 2 micrometres, a length along the channel length 1 of 10 micrometres and a depth (at the deepest part) into the semiconductor body of about 0.75 to 1 micrometres. Two grooves 8 may be provided per side of each source cell 10 as shown in Figure 1, although it would be possible for many more grooves 8 to be provided.

After formation of the grooves 8 and any subsequent cleaning of the given surface 3, a thin, for example 800 Angstrom, layer 6a of gate oxide is grown. A layer of doped polycrystalline silicon, in this example, is then provided on the gate oxide layer 6a to form the conductive layer 6b of the insulated gate layer and the two layers then patterned using conventional photolithographic and etching techniques to define the insulated gate layer 60 shown by thicker lines in Figure 1. Although not shown in Figures 2 and 3, the edges of the insulated gates 6 may be tapered as described in, for example, an article by G. Bell and W. Ladenhauf published in Siemens Forschungs-und Entwicklungs - Berichte Bd 9 (1980) Nr. 4 at pages 190 to 194.

After formation of the insulated gate layer 60, impurities to form the relatively shallow outer subsidiary regions 4a of the second regions 4 and impurities to form the source regions 5 are implanted and/or diffused into the semiconductor body 1 using the insulated gate layer 60 as a mask as is conventional in the art. In this example boron ions may be used to form the p conductivity type second regions 4 and arsenic (or phosphorus) ions to form the source regions 5. where the relatively deep central subsidiary regions 4b are provided, then these may be formed by introducing and at least partially driving-in the appropriate impurities, in this example boron ions, prior to formation of the insulated gate layer 60 and possibly also prior to formation of the grooves 8 so as to avoid the grooves 8 effecting the profile of the relatively deep relatively highly doped central subsidiary regions 4b. Alternatively, the grooves 8 may be dimensioned so that they terminate short of the relatively deep highly doped central subsidiary regions 4b.

After formation of the second and source regions 4 and 5, a layer 14 of relatively thick silicon oxide is deposited over the insulated gate layer 60 and then patterned to define windows for enabling the subsequent source metallisation 13 (Figure 3) and gate metallisation (not shown) to contact the source regions 5 and insulated gate layer 60, respectively. In order to reduce parasitic bipolar effects, the source metallisation 13 is arranged to short each source region 5 to the associated second region 4. This may be accomplished by conventional means for example, as shown in Figure 3, by etching an opening through a central part of each source region 5 or by masking a central portion of each source cell 10 from the impurities for forming the source regions 5. Metallisation 12 to provide the drain contact is deposited on the opposed surface 11 of the semiconductor body 10 in conventional manner.

The provision of the grooves 8 in the channel areas 7 increases, as indicated above, the width w of the channel areas 7 resulting in a reduction in the on-resistance of a vertical DMOSFET in accordance with the invention in comparison to the same vertical DMOSFET formed without the grooves 8. This reduction in the on resistance should enable the dimensions of the source cells 10 to be reduced still further so that the source cell density can be increased enabling a reduction in the overall dimension of a DMOSFET chip and enabling more chips to be fabricated from a single wafer.

As can be seen from Figure 2, the use of a DMOSFET technology in combination with the formation of the grooves 8 results in profiling or contouring of the source regions 5 to follow the profile of the surface regions 3b. However, the extent and degree of curvature produced by such profiling can be controlled by, for example, controlling and/or adjusting the cross-sectional profile of the grooves and/or by controlling and/or adjusting the number and depth of the grooves for the particular voltage rating desired.

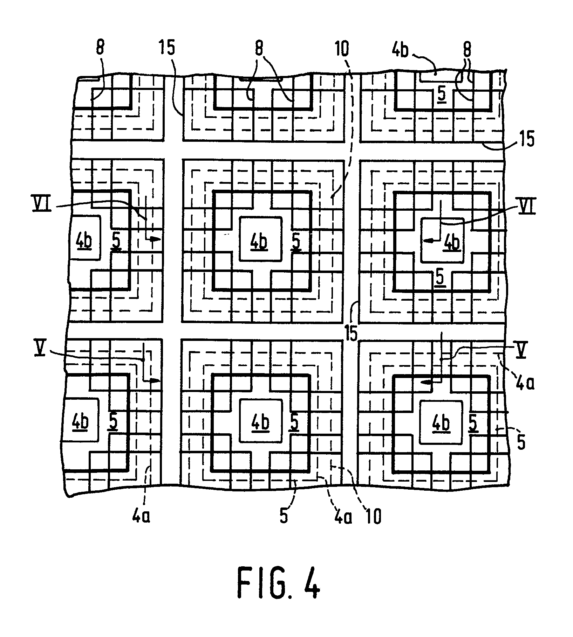

Figures 4 to 6 illustrate a modified version of the vertical DMOSFET shown in Figures 1 to 3.

The vertical DMOSFET shown in Figures 4 to 6 differs mainly from that shown in Figures 1 to 3 by the provision of additional or further grooves 15. As can be seen most clearly from Figure 4, the further grooves 15 effectively provide a boundary around each source cell 10 and extend across the grooves 8. As can be seen from Figures 4 to 6, the insulated gate layer 60 extends across and follows the grooves 15.

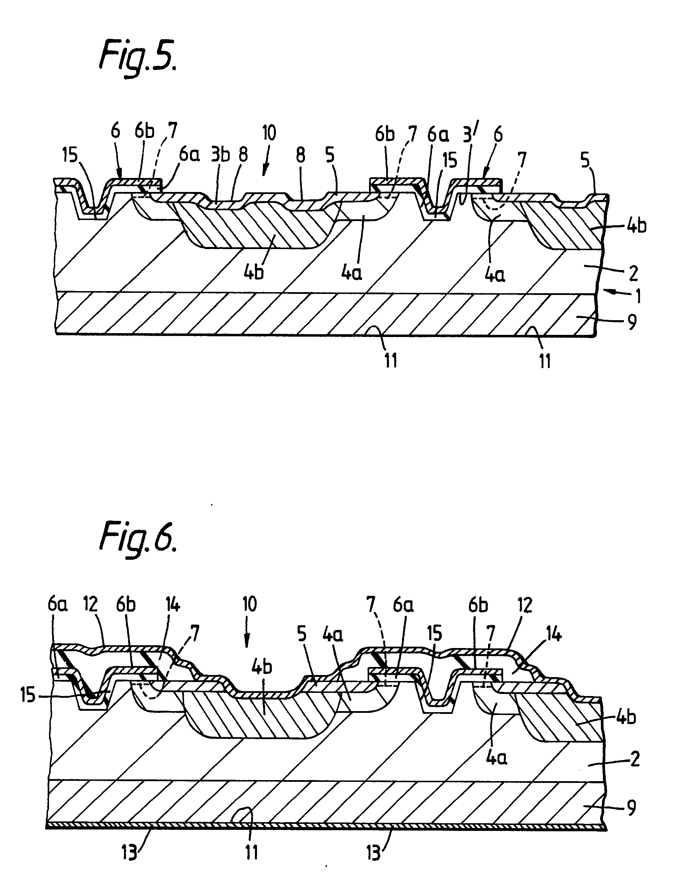

As shown in Figures 5 and 6, in this embodiment both the grooves 8 and the further grooves 15 are formed as flat-bottomed V grooves by a selective anisotropic etching technique, although any of the etching techniques mentioned above in relation to the formation of the grooves 8 may be used. It should, of course, be appreciated that in the interests of clarity the plan view of Figure 4 does not show the bottom edges of the side walls of the further grooves 15 which would of course be visible as the further grooves 15 have a frusto-conical shape. In this example, the further grooves 15 are both wider and deeper than the grooves 8 with the depth of the further grooves 15 being comparable to or greater than the depth of the outer subsidiary regions 4a of the second regions 4. The further grooves 15 will be formed as a first step and the gate oxide provided over the further grooves 15, after any necessary cleaning, so that, as shown in Figures 5 and 6, the insulated gates 6 follow the contours of the further grooves 15. With the source and second region 5 and 4 land cell dimension given above, then for a 50 volt device the further grooves 15 may have a depth (at the deepest part) of about 2 micrometres and a width of about 4 micrometres. Where the device is to be a 200 volt device, then the further grooves 15 may have a depth of about 4 micrometres and a width of about 6 micrometres.

In operation the device shown in Figures 4 to 6, an accumulation layer forms at the surface 3' and the surface of the grooves 15 beneath the insulated gate layer 60 which provides a relatively high mobility Conduction channel for carriers into the first region 2 so inhibiting pinch-off of the parasitic JFET and also facilitating a reduction in the on-resistance of the vertical MOSFET.

The further grooves 15 thus act to inhibit pinch-off of the parasitic JFET (Junction FET) defined by adjacent source cells 10 which enables adjacent source cells 10 to be placed closer together so facilitating an increase in the source cell density.

It should, of course, be appreciated that the conductivity types given above could be reversed and moreover that although the devices described above are enhancement-mode (normally off) devices, by appropriate doping of the channel areas 7 depletion-mode (normally on) devices could be formed. Also, the present invention may be applied to other MOS-gated devices, for example the devices shown in Figures 1 to 6 and described above could, by replacing the substrate 9 with opposite conductivity type material, be formed as insulated gate bipolar transistors as described in, for example, GB-A-2088631 and GB-A-2072422. Also, the embodiment shown in Figures 1 to 3 may be adapted to a lateral MOS-gated device, that is to a device where the main conduction path is parallel to the given surface, for example in the case of a MOSFET, where the source and drain contacts are both at the given surface.

Although the embodiments described above relate to silicon devices, a field effect semiconductor device embodying the invention may be formed using other semiconductor materials, for example a III-V semiconductor material such as gallium arsenide with appropriate conventional modification of the processing technology.

From reading the present disclosure, other modifications will be apparent to persons skilled in the art. Such modifications may involve other features which are already known in the semiconductor art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention. The applicants hereby give notice that new claims may be formulated to such features and/or combinations of such features during the prosecution of the present application or of any further application derived therefrom.

## Claims

1. A field effect semiconductor device comprising a semiconductor body having a first region of one conductivity type adjacent a given surface of the body, a second region of the opposite conductivity type provided within the first region adjacent the given surface, a third region of the one conductivity type provided in the second region adjacent the given surface and an insulated gate provided on the given surface overlying a channel area of the second region for defining a gateable conductive path along the length of the channel area between the third and first regions, characterised in that the given surface is profiled in the region of the channel area in a direction extending transversely of the length of the channel area so as to increase the effective width of the channel area.

2. A device according to Claim 1, further characterised in that the given surface is profiled in the region of the channel area by causing the given surface to undulate in the region of the channel area in a direction transverse to the conductive path.

3. A device according to Claim 2, further characterised in that the said region of the given surface is caused to undulate by defining one or more grooves in the said region of the given surface extending along the length of the channel area.

4. A device according to Claim 3, further characterised in that the or each groove has a smoothly varying profile in cross-section.

5. A device according to Claim 3, characterised in that the or each groove is formed by an anisotropic etching process which etches preferentially on planes parallel to the given surface.

6. A device according to any one of the preceding claims, further characterised in that the first region provides a conductive path from the third region via the gateable conductive path to an anode or drain adjacent a surface of the semiconductor body opposed to the given surface.

7. A device according to Claim 6, further characterised in that the semiconductor body has a plurality of second regions disposed spaced apart within the first region adjacent the given surface with respective third region being provided in each second region and a respective insulated gate being provided on the given surface overlying a channel area of the associated second region and the first region provides a conductive path from each third region via the associated gateable conductive path to a common anode or drain adjacent the surface of the semiconductor body opposed to the given surface.

8. A device according to Claim 7, characterised in that adjacent second regions are separated at the given surface by one or more further grooves extending into the given surface and the insulated gate extends over and follows the groove(s).

9. A device according to Claim 8, further characterised in that each further groove is of a depth similar to or greater than that of the adjacent second regions.

10. A field effect semiconductor device substantially as hereinbefore described with reference to, and as illustrated in, Figures 1 to 3 or Figures 4 to 6 of the accompanying drawings.

FIG.1

FIG.1a

*Fig.2.*

*Fig.3.*

FIG. 4

Fig.5.

Fig.6.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 393 391 (BLANCHARD) * Column 1, line 60 - column 4, line 2; figures 1,2B-3C * | 1-6 | H 01 L 29/60 H 01 L 29/06 H 01 L 29/784 H 01 L 29/72 H 01 L 29/10 |
| Y | | 7-10 | |
| Y | IEEE TRANSACTIONS ON ELECTRON DEVICES, vol. ED-31, no. 11, November 1984, pages 1570-1591, IEEE, New York, US; M.S. ADLER et al.: "The evolution of power device technology" * Page 1579, left-hand column, line 10 - right-hand column, line 10; figures 17a,17b,20 * | 7-10 | |
| A | IDEM | 1,6 | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 06-04-1990 | MORVAN D.L.D. |